# EUROPÄISCHE PATENTSCHRIFT

(11) **EP 3 218 283 B1**
(45) Veröffentlichungstag und Bekanntmachung des Hinweises auf die Patenterteilung: **26.09.2018**
(21) Anmeldenummer: 15786982.7
(22) Anmeldetag: 29.10.2015
(51) Int. Cl.: B65D 75/00, C01B 33/035, C30B 30/00, B65D 33/16, C01B 33/037

(54) **POLYKRISTALLINES SILICIUMSTABPAAR UND VERFAHREN ZUR HERSTELLUNG VON POLYKRISTALLINEM SILICIUM**
POLYCRYSTALLINE SILICON ROD PAIR AND METHOD FOR PRODUCING POLYCRYSTALLINE SILICON
PAIRE DE BARREAUX DE SILICIUM POLYCRISTALLIN ET PROCÉDÉ DE PRODUCTION DE SILICIUM POLYCRISTALLIN

(30) Priorität: 10.11.2014 DE 102014222883
(43) Veröffentlichungstag der Anmeldung: 20.09.2017
(73) Patentinhaber: Wacker Chemie AG, 81737 München (DE)
(72) Erfinder: VIETZ, Matthias, A-5230 Mattighofen (AT); FÄRBER, Stefan, 84577 Tüssling (DE)
(74) Vertreter: Potten, Holger
(86) Internationale Anmeldenummer: PCT/EP2015/075117
(87) Internationale Veröffentlichungsnummer: WO 2016/074939

(56) Entgegenhaltungen:
- EP-A1- 2 671 819
- EP-A2- 2 030 905
- CN-U- 201 598 183
- DATABASE WPI Week 201240 Thomson Scientific, London, GB; AN 2012-G20376 XP002752879, & JP 2012 101838 A (TOKUYAMA CORP) 31. Mai 2012 (2012-05-31)

## Beschreibung

Gegenstand der Erfindung sind ein polykristallines Siliciumstabpaar und ein Verfahren zur Herstellung von polykristallinem Silicium.

Polykristallines Silicium (kurz: Polysilicium) dient als Ausgangsmaterial bei der Herstellung von einkristallinem Silicium mittels Tiegelziehen (Czochralski- oder CZ-Verfahren) oder mittels Zonenschmelzen (Floatzone oder FZ-Verfahren). Dieses einkristalline Silicium wird in Scheiben (Wafer) zertrennt und nach einer Vielzahl von mechanischen, chemischen und chemo-mechanischen Bearbeitungen in der Halbleiterindustrie zur Fertigung von elektronischen Bauelementen (Chips) verwendet.

Insbesondere wird aber polykristallines Silicium in verstärktem Maße zur Herstellung von ein- oder multikristallinem Silicium mittels Zieh- oder Gieß-Verfahren benötigt, wobei dieses ein- oder multikristalline Silicium zur Fertigung von Solarzellen für die Photovoltaik dient.

Das polykristalline Silicium wird üblicherweise mittels des Siemens-Prozesses hergestellt. Dabei werden in einem glockenförmigen Reaktor (dem sog. "Siemens-Reaktor") Dünnstäbe aus Silicium durch direkten Stromdurchgang auf Oberflächentemperaturen von 900-1200 °C erhitzt und ein Reaktionsgas enthaltend eine Silicium enthaltende Komponente, insbesondere ein Halogensilan, und Wasserstoff über Einlassdüsen eingeleitet. Dabei zersetzen sich die Halogensilane an der Oberfläche der Dünnstäbe. Dabei scheidet sich elementares Silicium aus der Gasphase auf den Dünnstäben ab.

Die Siliciumstäbe werden dabei im Reaktor von speziellen Elektroden gehalten, die in der Regel aus hochreinem Elektrographit bestehen. Jeweils zwei Dünnstäbe mit unterschiedlicher Spannungspolung an den Elektrodenhalterungen sind am anderen Dünnstabende mit einer Brücke zu einem geschlossenen Stromkreis verbunden. Über die Elektroden und deren Elektrodenhalterungen wird elektrische Energie zur Beheizung der Dünnstäbe zugeführt.

Während der Abscheidung wächst der Durchmesser der Dünnstäbe. Gleichzeitig wächst die Elektrode, beginnend an ihrer Spitze, in den Stabfuß der Siliciumstäbe ein.

Als Werkstoff für die Elektroden wird hauptsächlich Graphit verwendet, da Graphit in sehr hoher Reinheit zur Verfügung steht und bei Abscheidebedingungen chemisch inert ist. Weiterhin hat Graphit einen sehr geringen spezifischen elektrischen Widerstand.

Nach dem Erreichen eines gewünschten Solldurchmessers der Siliciumstäbe wird der Abscheideprozess beendet, die glühenden Siliciumstäbe abgekühlt und ausgebaut.

Anschließend werden die erhaltenen U-förmigen Stabpaare aus Polysilicium üblicherweise elektroden- und brückenseitig abgelängt und zu Bruchstücken zerkleinert. Die Zerkleinerung erfolgt mittels eines Brechers, z.B. mit einem Backenbrecher. Ein solcher Brecher ist beispielsweise beschrieben in EP 338 682 A2. Gegebenenfalls erfolgt zuvor eine Vorzerkleinerung mittels eines Hammers. Zuvor wird üblicherweise die Graphitelektrode entfernt.

US 20120175613 A1 offenbart ein Verfahren zur Herstellung eines polykristallinen Siliciumstücks, bestehend aus einem CVD-Prozess zur Herstellung eines polykristallinen Siliciumstabs durch Abscheidung von Silicium auf einem Filamentdraht, dessen ein Ende an einer ersten Elektrode und dessen anderes Ende an einer zweiten Elektrode angeschlossen ist, einem Prozess zur Entnahme des polykristallinen Siliciumstabs aus dem Reaktor sowie einem Zerkleinerungsprozess des Siliciumstabs in Siliciumstücke, dadurch gekennzeichnet, dass vor dem Zerkleinerungsprozess mindestens 70 mm ab dem Elektrodenende vom polykristallinen Siliciumstab entfernt werden (Fußkürzungsprozess). In einer bevorzugten Ausführungsform wird die Oberfläche des polykristallinen Siliciumstabs vor der Entnahme aus dem Reaktor mit einem sackartigen Teil aus Polyethylen überzogen.

DE 10 2013 206 339 A1 offenbart ein Verfahren zum Ausbau von polykristallinen Siliciumstäben aus einem Reaktor, wobei der Reaktor U-förmige Stabpaare umfasst, wobei eines der U-förmigen Stabpaare von einem Körper mit einer Außenwand und einer Innenwand vollständig umschlossen wird und der Körper mitsamt dem von ihm umschlossenen Stabpaar mittels eines Kranes, eines Seilzuges oder eines Greifers aus dem Reaktor entfernt wird. Der Körper kann eine Innenwand aus Stahl aufweisen, wobei das Stabpaar, bevor es vom Körper umschlossen wird, mit einem Kunststoffsack überzogen wird.

Die bei den beiden zuvor genannten Verfahren verwendeten Kunststoffsäcke sollen den polykristallinen Siliciumstab vor Kontaminationen schützen.

CN 201 598 183 U beschreibt eine Umhüllung für einen Siliciumstab. Die Umhüllung hat eine Öffnung, mit welcher sie über den Siliciumstab gestülpt wird. Ferner verfügt die Öffnung über einen Gaseinlass. Die der Öffnung gegenüberliegende Seite der Umhüllung weist Gasauslassöffnungen auf, so dass ein über den Gaseinlass eingeblasenes Inertgas stetig entweichen kann.

JP 2012 101838 A beschreibt einen Packsack für ein Teilstück eines Siliciumstabes, wobei der Packsack eine 120 bis 350 mm dicke Harzschicht aufweist.

EP 2 030 905 A2 beschreibt einen mehrschichtigen Verpackungsbeutel für Siliciumbruchstücke.

EP 2 671 819 A1 beschreibt einen Zweifolienbeutel zur Verpackung von Siliciumbruchstücken oder Siliciumstabstücken, wobei eine innere Folie zwischen 10 und 1000 µm dick ist und eine äußere Folie eine Vertärkungsstruktur aufweist.

Allerdings hat sich gezeigt, dass es bei Kunststoffsäcken aus PE-Folie mit einer Dicke von 150 µm oder weniger zu Durchstoßungen des Kunststoffsäcke kommen kann, wenn diese über die polykristallinen Siliciumstäbe gezogen werden. Erfahrungsgemäß weisen bis zu 50% der eingesetzten Kunststoffsäcke Durchstoßungen auf. Als besonders problematisch hat sich dabei die Kontamination der polykristallinen Siliciumstäbe mit Fremdpartikeln erwiesen. Die Herkunft der Fremdpartikel ist überwiegend auf die Zerstörung der Kunststoffsäcke und entstandene Folienreste zurückzuführen.

Aus der beschriebenen Problematik ergab sich die Aufgabenstellung der Erfindung.

Die Aufgabe wird gelöst durch ein Verfahren zur Herstellung von polykristallinem Silcium, umfassend
a) Abscheidung von polykristallinem Silicium mittels CVD auf wenigstens einem U-förmigen Trägerkörper, der durch direkten Stromdurchgang auf eine Temperatur aufgeheizt wird, bei der sich polykristallines Silicium auf dem Trägerkörper abscheidet, wodurch wenigstens ein U-förmiges polykristallines Siliciumstabpaar entsteht, wobei der Trägerkörper an seinen freien Enden jeweils mit einer Graphitelektrode verbunden ist und auf diese Weise mit Strom versorgt wird;
b) Ausbau des wenigstens einen polykristallinen Siliciumstabpaares aus dem Reaktor;
c) Entfernen von Graphitresten von den elektrodenseitigen Enden der wenigstens zwei polykristallinen Siliciumstäbe des wenigstens einen polykristallinen Siliciumstabpaares;
d) Zerkleinerung der wenigstens zwei polykristallinen Siliciumstäbe zu Stabstücken oder zu Bruchstücken;
dadurch gekennzeichnet, dass vor dem Ausbau des wenigstens einen polykristallinen Siliciumstabpaares aus dem Reaktor das wenigstens eine polykristalline Siliciumstabpaar wenigstens teilweise mit einem Kunststoffsack aus einer Kunststofffolie mit einer Dicke von größer als 150 µm überzogen wird, wobei der Kunststoffsack im Bereich seiner Öffnung ein oder mehrere Gewichte umfasst.

Vorzugweise besteht die Kunststofffolie aus PE-LD.

Bei PE-LD handelt es sich um Polyethylen (PE) mit stark verzweigten Polymerketten und daher mit niedriger Dichte von 0,915 g/cm³ bis 0,935 g/cm³. "LD" steht für "Low density".

Beim den im Bereich der Öffnung des Kunststoffsacks vorgesehenen Gewichten kann es sich um ein einteiliges Gewicht handeln, das vorzugweise radial umlaufend im Bereich der Öffnung angeordnet ist.

Es kann sich jedoch auch um ein mehrteiliges Gewicht oder um mehrere Gewichtselemente handeln, die im Bereich der Öffnung am Umfang des Kunststoffsacks angeordnet sind.

Die Aufgabe wird auch gelöst durch ein polykristallines Siliciumstabpaar, mit einem Stabdurchmesser von 190 mm oder größer, das von einem Kunststoffsack aus einer Kunststofffolie mit einer Dicke von größer als 150 µm überzogen ist.

Die Erfinder haben erkannt, dass bei einem Kunststoffsack mit einer Foliendicke von größer als 150 µm die Steifigkeit der Folie derart zunimmt, dass es schwierig ist, den Kunststoffsack von oben über das Siliciumstabpaar und bis zum Reaktorboden zu ziehen. Mit zunehmendem Stabdurchmesser, insbesondere ab 190 mm, war es praktisch unmöglich, einen solchen Kunststoffsack über das Stabpaar zu ziehen.

Diese Probleme treten beim erfindungsgemäßen Verfahren nicht mehr auf.
Die angebrachten Gewichte beschweren den Kunststoffsack im Bereich seiner Öffnung, so dass es auch bei dicken Folien leichter wird, den Kunststoffsack über das Stabppar zu ziehen.
Zudem weisen im Gegensatz zu den zuvor verwendeten dünneren Foliendicken weniger als 5% der Kunststoffsäcke Durchstoßungen auf.

Die Gesamtmasse der befestigten Gewichte beträgt vorzugweise 20% bis 80% der Gesamtmasse der Kunststofffolie (ohne Gewichte).

Dazu eignen sich starre Gewichte aus Edelstahl, die sich in einer Schutzhülle von PE befinden und auf den Kunststoffsack aufgeschweißt werden.

Ebenso geeignet und besonders bevorzugt sind Gewichte aus Kunststoff.

Vorzugweise handelt es sich um einen flexiblen, aber stabilen Kunststoff.

Als mögliche Kunststoffe bieten sich hierbei Polyurethan (PU), Polyamid, Polyethylen, Polycarbonat und Polyethylenterephthalat an. Genauso sind Materialien aus Carbon oder Carbon-Bestandteilen oder Glasfaserverstärkte Kunststoffe (GFK) möglich.

Insbesondere PU-Streifen haben sich als vorteilhaft erweisen. Diese sind leicht handhabbar - auch in Verbindung mit einer Vorrichtung zum Stabausbau (Ausbauhilfe) - und lassen sich ohne Probleme anbringen und wieder entfernen. Damit sind sie ohne weiteres wiederverwendbar.

Vorzugweise hat der Kunststoffsack eine Dicke von 200 bis 500 µm, besonders bevorzugt von 220 µm bis 290 µm (nach ISO 5493 bzw. DIN 53370).

Die Dicke wird in einer Linie in der Mitte des Probestreifens an mindestens 10 Prüfpunkten über die gesamte Länge verteilt (Abstand max. 20 cm) gemessen und der arithmetische Mittelwert wird bestimmt.

Die Kunststofffolie des Kunststoffsacks besteht vorzugweise aus PE-LD mit einem Melt-Flow-Index von 0,26 g/10min (Prüftemperatur 190°C / Prüflast 2,16 kg, nach ISO 1133).

Der Melt-Flow-Index nach ISO 1133 wird mittels eines Kapillarrheometers ermittelt, wobei das Material in einem beheizbaren Zylinder aufgeschmolzen und unter einem durch die Auflagelast entstehenden Druck durch eine definierte Düse (Kapillare) gedrückt wird. Ermittelt wird das austretende Volumen bzw. Masse der Polymerschmelze (des sogenannten Extrudats) als Funktion der Zeit.

Vorzugweise beträgt die Durchstichfestigkeit der Folie (nach DIN EN 14477) etwa 5-6 N.

Mit dem Versuch nach EN 14477 wird die Durchstichfestigkeit gegenüber einer Spitze mit 0,8 mm Durchmesser gemessen. Dieser Versuch ist auch als "Parker-Pen-Test" bekannt.
Vorzugweise beträgt die Folienzugspannung (nach DIN EN ISO 527-3) bei 15% Dehnung in Längsrichtung 6-7 MPa, in Querrichtung 8-10 MPa.
Vorzugweise beträgt die Folienbruchspannung (nach DIN EN ISO 527-3) in Längs- und Querrichtung 9-11 MPa.

In der DIN EN ISO 527-3 ist beschrieben, wie die Folienzug- und Folienbruchspannung zu bestimmen sind. Es kommt der Prüfkörpertyp 2 (Streifenprobe) zum Einsatz. Dabei ist ein streifenförmiger Probekörper aus der Folie auszuschneiden oder auszustanzen, der eine Breite von 15 mm und eine Länge von mindestens 150 mm aufweist, sowie zwei parallele Messmarken in einem Abstand von 50 mm auf der Mitte des Probekörpers anzubringen.

In einer bevorzugten Ausführungsform werden die Gewichte nach dem Stabausbau entfernt.

Zur Abscheidung von polykristallinem Silicium wird ein Reaktionsgas enthaltend eine Silicium enthaltende Komponente und Wasserstoff in einen CVD-Reaktor eingeleitet.

Die Silicium enthaltende Komponente des Reaktionsgases ist vorzugsweise Monosilan oder Halogensilan der allgemeinen Zusammensetzung SiHnX₄-n (n=0, 1, 2, 3, 4; X = Cl, Br, I).

Besonders bevorzugt handelt es sich um ein Chlorsilan oder um ein Chlorsilangemisch.

Ganz besonders bevorzugt ist die Verwendung von Trichlorsilan.

Monosilan und Trichlorsilan werden vorzugsweise im Gemisch mit Wasserstoff eingesetzt.

Auf dem U-förmigen Trägerkörper scheidet sich hochreines Polysilicium ab, wodurch dessen Durchmesser mit der Zeit anwächst. Nachdem der gewünschte Durchmesser erreicht ist, wird der Abscheidungsprozess beendet.

Der Ausbau der Stabpaare kann mittels eines Kranes, eines Greifers oder dergleichen erfolgen.

Der Ausbau des wenigstens einen polykristallinen Siliciumstabpaares aus dem Reaktor erfolgt in einer weiteren Ausführungsform mittels einer sog. Ausbauhilfe, nämlich eines Körpers mit einer Außenwand und einer Innenwand, von dem das Siliciumstabpaar vollständig umschlossen wird, wobei der Körper mitsamt dem von ihm umschlossenen Siliciumstabpaar mittels eines Kranes, eines Seilzuges oder eines Greifers aus dem Reaktor entfernt wird.

Der Körper ist vorzugsweise so dimensioniert, dass seine Länge mindestens der Höhe des stehenden Stabpaares entspricht. Seine Breite beträgt vorzugsweise mindestens der Breite eines U-förmigen Siliciumstabpaares (Siliciumbrücke + Stabdurchmesser). Vorzugsweise beträgt seine Breite mindestens 200 mm, besonders bevorzugt mindestens 300 mm.

Vorzugsweise weist der Körper eine Innenwand aus Stahl, einem kontaminationsarmen Hartmetall oder einer abriebsarmen Keramik (z.B. Wolframcarbid, Titancarbid, Chromcarbid, Molybdäncarbid, Vanadiumcarbid und Nickelcarbid, Siliciumcarbid) auf. Bevorzugt ist auch die Verwendung eines Körpers enthaltend eine Stahlinnenwand, wobei die Innenwand des Körpers mit einem solchen kontaminationsarmen Hartmetall oder mit einer abriebsarmen Keramik teilweise oder vollflächig beschichtet ist.

Vorzugweise weist die Ausbauhilfe eine Öffnung auf, durch die das wenigstens eine polykristalline Siliciumstabpaar nach der Entfernung aus dem Reaktor aus dem Körper herausragt oder gehoben wird, so dass jeder Siliciumstab des Siliciumstabpaares um höchstens 500 mm seiner Länge aus der Öffnung des Körpers herausragt, wobei anschließend die Graphitreste von den elektrodenseitigen Enden der wenigstens zwei Siliciumstäbe entfernt werden.

Vorzugsweise umfasst der Körper eine händisch oder mittels eines mechanischen oder elektrischen Mechanismus schließbare Klappe an einer Öffnung des Körpers, so dass sich das U-förmige Stabpaar komplett im Körper einschließen und so aus dem Reaktor heben lässt. Der Abtransport des herausgehobenen Stabpaares zu weiterverarbeitenden Prozessen erfolgt vorzugsweise mittels eines Transportwagens.

Der Einsatz von Kunststoffgewichten ist besonders vorteilhaft, da es aufgrund der Flexibilität des Kunststoffes zu keinem Verklemmen des Schließmechanismus der Ausbauhilfe kommen kann, das bei der Verwendung von starren Edelstahlgewichten gelegentlich zu beobachten war. Flexible Gewichte sind also gegenüber starren Gewichten zu bevorzugen.

Ebenso konnte durch Kunststoffgewichte auch eine Vermeidung von unerwünschten Fe/Cr/Ni Verunreinigungen am Polysilcium verhindert werden. So sind bei Verwendung von Edelstahlgewichten oberflächliche Kontaminationen des Siliciums von bis zu 12000 pptw Fe, 2280 pptw Cr u. 1200ppt Ni messbar, auch wenn die die starren Foliengewichte durch zwei oder mehr Lagen PE-Folie vom Polysilicium abgekapselt waren.

Vorzugweise sind die Siliciumstäbe während des Entfernens der Graphitreste von den elektrodenseitigen Enden zumindest teilweise von einem Kunststoffsack überzogen. Vorzugweise sind die Siliciumstäbe jeweils bis zu einem Abstand von mindestens 5 mm von den elektrodenseitigen Enden mit einem Kunststoffsack überzogen. So kann vermieden werden, dass der Kunststoffsack von den Graphitresten kontaminiert wird.

Vorzugweise erfolgt das Abschlagen der Graphitreste, während sich das wenigstens eine Siliciumstabpaar in der Ausbauhilfe befindet.

Nach dem Herausheben der Stäbe aus dem Reaktor kann das Abschlagen der Graphitreste erfolgen, während sich das Stabpaar noch im Körper befindet.

Zu diesem Zweck wird das Stabpaar beispielsweise mittels eines Greifers aus der Ausbauhilfe gehoben, so dass jeder Stabfuß weniger als 500 mm, besonders bevorzugt weniger als 300 mm und ganz besonders bevorzugt weniger als 100 mm aus der Öffnung der Ausbauhilfe herausragt. In dieser Konstellation erfolgt dann das Abschlagen der Graphitreste von den Stäben, wobei zumindest die nicht aus der Öffnung der Ausbauhilfe herausragenden Teile der Stäbe von einem Kunststoffsack überzogen sind.

Die Siliciumstäbe werden zu Stabstücken oder Bruchstücken zerkleinert. Zuvor wird selbstverständlich der Kunststoffsack vom Stabpaar entfernt.

Bei der Zerkleinerung zu Stabstücken können nach Entfernung der Graphitreste von den elektrodenseitigen Enden der Stäbe ein oder mehrere Stabstücke von einem oder von beiden Enden der Stäbe abgetrennt werden.

Besonders bevorzugt ist es, die Siliciumstäbe zu Bruchstücken zu zerkleinern.

Die Zerkleinerung der Siliciumstäbe zu Bruchstücken erfolgt vorzugweise mittels eines Backen- oder Walzenbrechers. Gegenfalls erfolgt zuvor eine Vorzerkleinerung mittels geeigneter Schlagwerkzeuge.

Die bezüglich der vorstehend aufgeführten Ausführungsformen des erfindungsgemäßen Verfahrens angegebenen Merkmale können entsprechend auf das erfindungsgemäße Erzeugnis übertragen werden. Umgekehrt können die bezüglich der vorstehend ausgeführten Ausführungsformen des erfindungsgemäßen Erzeugnisses angegebenen Merkmale entsprechend auf das erfindungsgemäße Verfahren übertragen werden.

Die bezüglich der vorstehend aufgeführten Ausführungsformen des erfindungsgemäßen Verfahrens angegebenen Merkmale können entweder separat oder in Kombination als Ausführungsformen der Erfindung verwirklicht werden. Weiterhin können sie vorteilhafte Ausführungen beschreiben, die selbstständig schutzfähig sind.

Die vorstehende Beschreibung umfasst andererseits im Verständnis des Fachmanns auch offensichtliche Abänderungen und Modifikationen des beschriebenen Verfahrens. Daher sollen alle derartigen Abänderungen und Modifikationen sowie Äquivalente durch den Schutzbereich der Ansprüche abgedeckt sein.

## Patentansprüche

1. Verfahren zur Herstellung von polykristallinem Silcium, umfassend
a) Abscheidung von polykristallinem Silicium mittels CVD auf wenigstens einem U-förmigen Trägerkörper, der durch direkten Stromdurchgang auf eine Temperatur aufgeheizt wird, bei der sich polykristallines Silicium auf dem Trägerkörper abscheidet, wodurch wenigstens ein U-förmiges polykristallines Siliciumstabpaar entsteht, wobei der Trägerkörper an seinen freien Enden jeweils mit einer Graphitelektrode verbunden ist und auf diese Weise mit Strom versorgt wird;
b) Ausbau des wenigstens einen polykristallinen Siliciumstabpaares aus dem Reaktor
c) Entfernen von Graphitresten von den elektrodenseitigen Enden der wenigstens zwei polykristallinen Siliciumstäbe des wenigstens einen polykristallinen Siliciumstabpaares;
d) Zerkleinerung der wenigstens zwei polykristallinen Siliciumstäbe zu Stabstücken oder zu Bruchstücken;
**dadurch gekennzeichnet, dass** vor dem Ausbau des wenigstens einen polykristallinen Siliciumstabpaares aus dem Reaktor das wenigstens eine polykristalline Siliciumstabpaar wenigstens teilweise mit einem Kunststoffsack aus einer Kunststofffolie mit einer Dicke von größer als 150 µm überzogen wird, wobei der Kunststoffsack im Bereich seiner Öffnung ein oder mehrere Gewichte umfasst.

2. Verfahren nach Anspruch 1, wobei eine Gesamtmasse der Gewichte am Kunststoffsack 20% bis 80% der Gesamtmasse der Kunststofffolie beträgt.

3. Verfahren nach Anspruch 1 oder nach Anspruch 2, wobei es sich bei den Gewichten um starre Gewichte aus Edelstahl handelt, die sich jeweils in einer Schutzhülle aus PE befinden, wobei die Schutzhüllen enthaltend Gewichte aus Edelstahl auf den Kunststoffsack aufgeschweißt sind.

4. Verfahren nach Anspruch 1 oder nach Anspruch 2, wobei die Gewichte aus Kunststoff, ausgewählt aus der Gruppe bestehend aus Polyurethan, Polyethylen, Polyamid, Polycarbonat und Polyethylenterephthalat, bestehen.

5. Verfahren nach Anspruch 1 oder nach Anspruch 2, wobei die Gewichte aus Carbon oder Glasfaserverstärktem Kunststoff bestehen.

6. Verfahren nach einem der Ansprüche 1 bis 5, wobei die Kunststofffolie des Kunststoffsacks aus PE-LD besteht und eine Dicke von 200 µm bis 500 µm aufweist.

7. Verfahren nach Anspruch 6, wobei die Folie aus PE-LD eine Dicke von 220 bis 290 µm aufweist.

8. Verfahren nach einem der Ansprüche 1 bis 7, wobei der Ausbau des wenigstens einen polykristallinen Siliciumstabpaares aus dem Reaktor mittels eines Körpers mit einer Außenwand und einer Innenwand erfolgt, von dem das Siliciumstabpaar vollständig umschlossen wird, wobei der Körper mitsamt dem von ihm umschlossenen Siliciumstabpaar mittels eines Kranes, eines Seilzuges oder eines Greifers aus dem Reaktor entfernt wird, wobei die am Kunststoffsack befindlichen Gewichte nach dem Stabausbau entfernt werden.

9. Verfahren nach Anspruch 8, wobei der Körper eine Öffnung aufweist, durch die das wenigstens eine polykristalline Siliciumstabpaar nach der Entfernung aus dem Reaktor aus dem Körper herausragt oder gehoben wird, so dass jeder Siliciumstab des Siliciumstabpaares um höchstens 500 mm seiner Länge aus der Öffnung des Körpers herausragt, wobei anschließend die Graphitreste von den elektrodenseitigen Enden der wenigstens zwei Siliciumstäbe entfernt werden.

10. Verfahren nach einem der Ansprüche 1 bis 9, wobei die Siliciumstäbe während des Entfernens der Graphitreste von den elektrodenseitigen Enden jeweils bis zu einem Abstand von mindestens 5 mm von den elektrodenseitigen Enden mit dem Kunststoffsack überzogen sind.

11. Polykristallines Siliciumstabpaar, mit einem Stabdurchmesser von 190 mm oder größer, das von einem Kunststoffsack aus einer Kunststofffolie mit einer Dicke von größer als 150 µm überzogen ist, wobei der Kunststoffsack im Bereich seiner Öffnung ein oder mehrere Gewichte umfasst.

## Claims

1. Method of producing polycrystalline silicon comprising
a) depositing polycrystalline silicon by CVD on at least one U-shaped support body heated by direct passage of current to a temperature at which polycrystalline silicon is deposited on the support body to form at least one U shaped polycrystalline silicon rod pair, wherein each free end of the support body is connected to a respective graphite electrode and thus supplied with current;
b) deinstalling the at least one polycrystalline silicon rod pair from the reactor;
c) removing graphite residues from the electrode-side ends of the at least two polycrystalline silicon rods of the at least one polycrystalline silicon rod pair;
d) comminuting the at least two polycrystalline silicon rods into rod pieces or into chunks;
**characterized in that** prior to deinstallation of the at least one polycrystalline silicon rod pair from the reactor it comprises at least partially covering the at least one polycrystalline silicon rod pair with a plastics material bag made of a plastics material film having a thickness of more than 150 µm, wherein the plastics material bag comprises one or more weights in the region of its opening.

2. Method according to Claim 1, wherein the total mass of the weights at the plastics material bag is 20% to 80% of the total mass of the plastics material film.

3. Method according to Claim 1 or according to Claim 2, wherein the weights are rigid weights made of stainless steel which are each disposed in a respective protective PE shell, wherein the protective shells comprising weights made of stainless steel are welded onto the plastics material bag.

4. Method according to Claim 1 or according to Claim 2, wherein the weights are made of plastics material selected from the group consisting of polyurethane, polyethylene, polyamide, polycarbonate and polyethylene terephthalate.

5. Method according to Claim 1 or according to Claim 2, wherein the weights are made of carbon-fiber-reinforced plastic or glass-fiber-reinforced plastics material.

6. Method according to any of Claims 1 to 5, wherein the plastics material film of the plastics material bag is made of LDPE and has a thickness of from 200 µm to 500 µm.

7. Method according to Claim 6, wherein the film made of LDPE has a thickness of from 220 to 290 µm.

8. Method according to any of Claims 1 to 7, wherein the deinstallation of the at least one polycrystalline silicon rod pair from the reactor is achieved using a body which has an outside wall and an inside wall and which completely envelops the silicon rod pair, wherein the body, together with the silicon rod pair enveloped by it, is removed from the reactor using a crane, a winch or a grab, wherein the weights disposed at the plastics material bag are removed after rod deinstallation.

9. Method according to Claim 8, wherein the body has an opening through which the at least one polycrystalline silicon rod pair protrudes from, or is lifted out of, the body after removal from the reactor such that each silicon rod of the silicon rod pair protrudes by not more than 500 mm of its length out of the opening in the body, wherein the graphite residues are subsequently removed from the electrode-side ends of the at least two silicon rods.

10. Method according to any of Claims 1 to 9, wherein during removal of the graphite residues from the electrode-side ends the silicon rods are each covered by the plastics material bag up to a distance of not less than 5 mm from the electrode-side ends.

11. Polycrystalline silicon rod pair which has a rod diameter of 190 mm or more and is covered by a plastics material bag made of a plastics material film having a thickness of more than 150 µm, wherein the plastics material bag comprises one or more weights in the region of its opening.

## Revendications

1. Procédé pour la production de silicium polycristallin, comprenant
a) le dépôt de silicium polycristallin par CVD sur au moins un corps de support en forme d'U, qui est chauffé par passage direct de courant jusqu'à une température à laquelle du silicium polycristallin se dépose sur le corps de support, de sorte qu'il en résulte au moins une paire de barres de silicium polycristallin en forme d'U, le corps de support étant relié à chacune de ses extrémités libres à une électrode en graphite et étant de cette façon alimenté en courant ;
b) l'enlèvement de ladite au moins une paire de barres de silicium polycristallin hors du réacteur
c) l'élimination de restes de graphites des extrémités côté électrode desdites au moins deux barres de silicium polycristallin de ladite au moins une paire de barres de silicium polycristallin ;
d) fragmentation desdites au moins deux barres de silicium polycristallin en fragments de barres ou en éclats ;
**caractérisé en ce qu'**avant l'enlèvement de ladite au moins une paire de barres de silicium polycristallin hors du réacteur on recouvre au moins en partie ladite au moins une paire de barres de silicium polycristallin avec un sac en matière plastique à base d'un film de matière plastique ayant une épaisseur de plus de 150 µm, le sac en matière plastique comprenant dans la zone de son ouverture un ou plusieurs poids.

2. Procédé selon la revendication 1, dans lequel une masse totale des poids sur le sac en matière plastique représente 20 % à 80 % de la masse totale du film de matière plastique.

3. Procédé selon la revendication 1 ou selon la revendication 2, dans lequel pour ce qui est poids il s'agit de poids rigides en acier inoxydable qui se trouvent chacun dans une enveloppe protectrice en PE, les enveloppes protectrices contenant des poids en acier inoxydable étant soudées sur le sac en matière plastique.

4. Procédé selon la revendication 1 ou selon la revendication 2, dans lequel les poids sont constitués de matière plastique, choisie dans le groupe constitué par le polyuréthane, le polyéthylène, le polyamide, le polycarbonate et le poly(éthylène téréphtalate).

5. Procédé selon la revendication 1 ou selon la revendication 2, dans lequel les poids sont constitués de matière plastique renforcée avec des fibres de verre ou de carbone.

6. Procédé selon l'une quelconque des revendications 1 à 5, dans lequel le film de matière plastique du sac en matière plastique est constitué de PE-LD et présente une épaisseur de 200 µm à 500 µm.

7. Procédé selon la revendication 6, dans lequel le film de PE-LD présente une épaisseur de 220 à 290 µm.

8. Procédé selon l'une quelconque des revendications 1 à 7, dans lequel l'enlèvement de ladite au moins une paire de barres de silicium polycristallin hors du réacteur s'effectue au moyen d'un corps comportant une paroi externe et une paroi interne, par lequel la paire de barres de silicium est entièrement entourée, dans lequel on retire du réacteur le corps conjointement avec la paire de barres de silicium entourée par celui-ci au moyen d'une grue, d'une traction par câble ou d'un grappin, dans lequel après l'enlèvement de la barre on élimine les poids se trouvant sur le sac en matière plastique.

9. Procédé selon la revendication 8, dans lequel le corps comporte une ouverture, à travers laquelle après l'enlèvement hors du réacteur on fait ressortir ou lève du corps ladite au moins une paire de barres de silicium polycristallin, de sorte que chaque barre de silicium de la paire de barre de silicium dépasse d'au maximum 500 mm de sa longueur de l'ouverture du corps, les restes de graphite étant ensuite éliminés des extrémités côté électrode desdites au moins deux barres de silicium.

10. Procédé selon l'une quelconque des revendications 1 à 9, dans lequel pendant l'élimination des restes de graphite des extrémités côté électrode les barres de silicium sont recouvertes avec le sac en matière plastique chacune jusqu'à une distance d'au moins 5 mm des extrémités côté électrode.

11. Paire de barres de silicium polycristallin, ayant un diamètre de barre de 190 mm ou plus, qui est recouverte par un sac en matière plastique à base d'un film de matière plastique ayant une épaisseur de plus de 150 µm, le sac en matière plastique comprenant un ou plusieurs poids dans la zone se son ouverture.
